**Europäisches Patentamt**

(19) **European Patent Office**

**Office européen des brevets**

(11) Publication number: **0 147 871**
**A2**

## (12) EUROPEAN PATENT APPLICATION

(21) Application number: **84116513.7**

(22) Date of filing: **31.12.84**

(51) Int. Cl.⁴: **H 01 B 1/12**

(30) Priority: **30.12.83 PL 245450**
**15.11.84 PL 250436**

(43) Date of publication of application:
**10.07.85 Bulletin 85/28**

(84) Designated Contracting States:
**BE CH DE FR GB IT LI NL**

(71) Applicant: **POLSKA AKADEMIA NAUK CENTRUMBADAN MOLEKULARNYCH I MAKROMOLEKULARNYCH**
**ul. Boczna 5**
**90-364 Lodz(PL)**

(72) Inventor: **Kryszewski, Marian**
**ul. Dabrowskiego 3/6**
**Lodz(PL)**

(72) Inventor: **Pecherz, Janusz**
**ul. Asnyka 63/16**
**Kalisz(PL)**

(74) Representative: **Hansen, Bernd, Dr.rer.nat. et al,**
**Hoffmann, Eitle & Partner Patentanwälte Arabellastrasse 4**
**D-8000 München 81(DE)**

(54) Method of manufacturing high-molecular electrically conducting material.

(57) A method of manufacturing high-molecular electrically conducting material by means of doping the dissolved polymer with the admixtures of organic matter and spreading the solution onto a base consists, according to the invention, in doping the dissolved polymer with 0.1 - 5% /by weight in relation to polymer/ of the admixture of high-molecular compound containing iterative units of general formula 1, where $R_1$ denotes the methyl group, $R_2$ denotes independently the group of formula 2, the group of formula 3 or the group of formula $/-CH_2-/_x$, where x denotes the number 3 - 10, A denotes independently the atom of sulphur, nitrogen, phosphorus or arsenic, m being 0 if A denotes the sulphur atom or m being 1 if A denotes the atom of nitrogen, phosphorus or arsenic, or the substituent A is the above mentioned heteroatom in the aromatic ring of formula 4; the substituent $R_2$ denotes then independently the group of formula $/-CH_2-/_x$, where x is as above, the group of formula $-CH = CH-$ or $-CH_2-CH_2-$, $x°$ denotes neutral molecule from the group of acceptors capable of forming high-conductivity complexes with charge transfer, comprising 7, 7, 8, 8 - tetracyanoquinodimethane, its derivatives such as dibromotetracyanoquinodimethane, tetrafluorotetracyanoquinodimethane and dichlorotetracyanoquinodimethane, tetracyanonaphthaloquinodimethane, o-chloranil, p-benzoquinone; $x^-$ denotes anion-radical from the group of acceptors capable of forming high-conductivity complexes with charge transfer, comprising 7, 7, 8, 8 - tetracyanoquinodimethane, its derivatives such as dibromotetracyanoquinodimethane, tetrafluorotetracyanoquinodimethane and dichlorotetracyanoquinodimethane, tetracyanonaphthaloquinodimethane, o-chloranil, p-benzoquinone; the molar ratio $[x°]/[x^-]$ has the value lying within the range 0 - 1 on condition that if this ratio is equal to 0, one adds to the solution 0.1 - 3% /by weight in relation to polymer/ of neutral molecules from the group of acceptors capable of forming high-conductivity complexes with charge transfer, comprising 7, 7, 8, 8 - tetracyanoquinodimethane, its derivatives such as dibromotetracyanoquinodimethane, tetrafluorotetracyanoquinodimethane and dichlorotetracyanoquinodimethane, tetracyanonaphthaloquinodimethane, o-chloranil, p-benzoquinone.

The material manufactured according to the invention is applied especially as the material screening electromagnetic radiation, the material collecting and carrying away electric charge, the material for conductive paths and the material for resistive paths in potentiometers.

./...

EP 0 147 871 A2

$$\left[ \begin{array}{c} \overset{R_1}{\underset{|}{\phantom{-}}} \qquad \overset{R_1}{\underset{|}{\phantom{-}}} \\ -A^+ - R_2 - A^+ - R_2 - \\ \underset{(R_1)_m}{|} \qquad \underset{(R_1)_m}{|} \\ \\ X^{\bar{.}}... \quad X^{\circ}... \quad X^{\bar{.}}... \quad X^{\circ} \end{array} \right]$$

*form. 1*

## Method of manufacturing high-molecular
## electrically conducting material

The invention relates to a method of manufacturing high-molecular electrically conducting material, applied especially as the material screening electromagnetic radiation, the material collecting and carrying away electric charge, the material for conductive paths and the material for resistive paths in potentiometers.

There are known methods of manufacturing high-molecular materials of small specific resistance, consisting in doping polymers with large quantities of mineral matter such as carbon black or metalic powders. These methods need applying complex technology, and besides, the presence of admixtures aggravates mechanical and optical properties of matrix polymer.

The above methods have been described in a book "Conductive Rubbers and Plastics" by R.H.Norman, Elsevier Publishing Co., 1970, in the British Patent No 828 233 and in a monograph "Carbon Black Composites" E.K.Sicher, M.Dekker, /Physics of Electrically Conducting Composites, Ins. New York, 1982/.

One also knows methods of manufacturing polymer mixture with the admixtures of organic matter capable of forming complexes with charge transfer, being characterized by molecular diffusion of admixtures in the polymer, revealing photoconductive properties and having large specific resistance in darkness /Polish Patent No 92 245/.

There are known methods of manufacturing polymers with organic admixtures forming complexes with charge transfer of over 20% by weight.

One also knows methods of manufacturing conducting polymers with the admixtures of low-molecular complexes of tetracyanoquinodimethane of 20-40% by weight and even more. These methods have been described in the following papers:. Mirogushi, Nippon Kagaku Kaishi, 7, 1029 /1977/; S. Ikono, K. Matsumoto, M. Yokoyma, H. Mikawa, Polymer I, 9, 261 /1977/; J. Kishimoto, T. Hayaski, M. Hashimoto, T. Ohshima, J. Appl. Polym. Sci., 21, 2721 /1977/ and 24, 465 /1979/, as well as in the American Patent No 3 632 526.

The doping of polymers with such large quatities of admixtures enable manufacturing material of small specific resistance but aggravates substantially mechanical, thermal and optical properties.

The Polish Patent No 116 850 presents the method of manufacturing high-molecular electrically conducting material, consisting in doping the dissolved polymer with the admixtures of organic matter of small molecular weight capable of forming complex with charge transfer, being called "organic metals". Materials obtained in this way are characterized by small specific resistance but the applied admixtures of "organic metals" are very expensive, often more expensive than gold. This concerns especially donors like tetratiotetracene, tetratioful- valenq, tetraselenofulvalene and tetraselenotetracene.

Moreover, the solvents used in manufacturing those materials, e.g. chlorobenzene or o-dichlorobenzene are liquids of high boiling point. High temperature causes some difficulties that are connected with the removal of solvent from the conductive material, the presence of which may influence stability of these systems.

According to the invention, the method of manufacturing high-molecular electrically conducting material consists in that the polymer is being dissolved in solvent and then one adds 0.1 - 5% /by weight in relation to polymer/ of the admixture of high-molecular compound containing iterative monomeric units of general formula 1, where $R_1$ denotes the methyl group, $R_2$ denotes independently of the group formula 2, the group of formula 3 or the group of formula /$-CH_2-/_x$, where x denotes the number 3-10, A denotes independently the atom of sulphur, nitrogen, phosphorus or arsenic, im being 0 if A denotes the sulphur atom or m being 1 if A denotes the atom of nitrogen, phosphorus or arsenic, or the substituent A is a heteroatom in the aromatic ring of formula 4; the substituent $R_2$ denotes then independently the group of formula /$-CH_2-/_x$, where x is as above, the group of formula $-CH = CH-$ or $-CH-CH_2-$, $x^-$ denotes anion-radical from the group of acceptors capable of forming high-conductivity complex with charge transfer, comprising 7, 7, 8, 8 - tetracyanoquinodimethane /$TCNQ^-$/, its derivatives such as dibromotetracyanoquinodimethane, tetrafluorotetracyanoquinodimethane and dichlorotetracyanoquino-dimethane, tetracyanonaphthaloquinodimethane, o-chloranil, p--benzoquinone and $x^0$ denotes neutral molecule from the group of acceptors of capable forming high-conductivity complexes with charge transfer, comprising 7, 7, 8, 8-tetracyanoquinodimethane /TCNQ/, its derivatives such as dibromotetracyanoquinodimethane, tetrafluorotetracyanoquinodimethane and dichlorotetracyanoquino-dimethane, tetracyanonaphthaloquinodimethane, o-chloranil, p--benzoquinone; the molar ratio $[x^0]/[x^-]$ has the value given by the inequality $0 < [x^0]/[x^-] \leq 1$.

The obtained solution is then being spread onto a base and the solvent is being evaporated, the temperature of the base being chosen so as to get the material with the crystallized admixture of conducting complex salt after complete evaporation of the solvent.

An alternative procedure carried on according to the invention consists in that the polymer is being dissolved in solvent and then one adds 0.1 -5% /by weight in relation to polymer/ of the admixture of high-molecular compound containing iterative monomeric units of general formula 1, where the substituents have the denotation given above with the molar ratio $[x^0]/[x^-]$ equal to 0 and one adds 0.1 -3% /by weight in relation to polymer/ of neutral molecules from the group of acceptors capable of forming high-conductivity complexes with

- 5 -                                    0147871

charge transfer, comprising 7, 7, 8, 8-tetracyanoquinodimethane, its derivatives such as dibromotetracyanoquinodimethane, tetrafluorotetracyanoquinodimethane and dichlorotetracyanoquino-dimethane, tetracyanonaphthaloquinodimethane, o-chloranil, p-benzoquinone.

The obtained solution is then being spread onto a base and the solvent is being evaporated, the temperature of the base being chosen so as to get the material with the admixture of conducting complex salt after complete evaporation of the solvent; the former belongs to the group of acceptors capable of forming high-conductivity complexes with charge transfer, com-prising 7, 7, 8, 8- tetracyanoquinodimethane, its derivatives such as dibromotetracyanoquinodimethane, tetrafluorotetracyano-quinodimethane and dichlorotetracyanoquinodimethane, tetra-cyanonaphthaloquinodimethane, o-chloranil, p-benzoquinone that are not formed before obtaining the material.

The solvents used according to the invention are chosen so that the admixtures should also dissolve in them and should not form complexes either with the solvent or with the polymer. High-molecular admixtures used according to the invention are oligomers and high-molecular compounds containing 5 -50 or more iterative monomeric units of the above given formula 1.

According to the invention, the admixture may be high-molecular conducting complex salt that crystallizes during for-mation of the material and consists of units of formula 1, the molar ratio having the value given by the inequality $0 < [x^0]/[x^-] \leq 1$, or high-molecular simple salt consisting of units of formula 1, the molar ratio $[x^0]/[x^-]$ being equal to 0.

In case of using simple salt, one adds to the solution the neutral molecule from the group of acceptors capable of forming high-conductivity complexes with charge transfer, comprising 7, 7, 8, 8 - tetracyanoquinodimethane, tetrafluorotetracyanoquinodimethane and dichlorotetracyanoquinodimethane, tetracyanonaphthaloquinodimethane, o-chloranil, p-benzoquinone, so that the complex is not formed before obtaining the material.

According to the invention, the admixtures used are high-molecular complex salts containing iterative monomeric units of formula 5, 6, 7 and 11, where x and y denote independently the number 3 -10, n is 5 - 50 or more and A in the formula 11 denotes the atom of nitrogen.

The advantageous simple salts are high-molecular compounds containing iterative monomeric units of formula 8, 9 and 10, where x and y denote independently the number 3 - 10 and n is 5 - 50 or more.

The material obtained according to the invention is characterized by small specific resistance controlled by admixture concentration, temperature and rate of evaporation of the solvent, within the range of $10^1-10^5\Omega\cdot cm$, for admixture con-

centration of 0.1 - 5% /by weight/. This material is also characterized by a weak  dependence of conductivity on the temperature within the wide temperature range. Moreover, it has mechanical properties differing insignificantly from those of pure polymer constituting a matrix, it is partly transparent, does not change the physical properties with time and does not show the fatigue effect.

The examples given below illustrate the method according to the invention, not limiting its range.

Example 1. 100 parts by weight of methyl polymethacrylate /PMMA/ have been dissolved in 5000 parts by weight of acetone at a temperature of 320 K, and then 4 parts by weight of complex salt of formula 7, where x = 5 have been added and dissolved at the same temperature. The solution prepared in this manner has been poured onto a glass plate of a temperature of 310 K. The foil 15 $\mu m$ thick of light green colour and specific conductivity of 2.5 x $10^{-2} \Omega^{-1}$ cm$^{-1}$ at the room temperature has been obtained.

Example 2. 100 parts by weight of methyl polymethacrylate /PMMA/ have been dissolved in 5000 parts by weight of acetone at a temperature of 320 K, and then 4 parts by weight of complex salt of formula 7, where x = 6 have been added and dissolved at the same temperature. The solution prepared in this manner has been poured onto a glass plate of a temperature of 310 K. The foil 14 $\mu m$ thick of light green colour and specific con-

ductivity of $8.8 \times 10^{-3} \Omega^{-1}$ cm$^{-1}$ at the room temperature has been obtained.

Example 3. 100 parts by weight of polyacrylonitrile /PAN/ have been dissolved in 5000 parts by weight of dimethylformamide /DMF/ at a temperature of 340 K, and then 4 parts by weight of complex salt of formula 5, where $x = 6$, $X^- = TCNQ^-$, $X^0 = TCNQ$ have been added and dissolved at the same temperature. The solution prepared in this manner has been poured onto a glass plate of a temperature of 330 K. The foil 16 $\mu$m thick of light green colour and specific conductivity of $1.5 \times 10^{-4}$ $\Omega^{-1}$ cm$^{-1}$ at the room temperature has been obtained.

Example 4. 100 parts by weight of polyacrylonitrile /PAN/ have been dissolved in 5000 parts by weight of dimethylformamide /DMF/ at a temperature of 340 K, and then 2.40 parts by weight of simple salt of formula 8, where $x = 4$, $y = 6$, $X^- = TCNQ^-$ and 1.60 parts by weight of 7, 7, 8, 8 - tetracyanoquinodimethane have been added and dissolved at the same temperature. The solution prepared in this manner has been poured onto a glass plate of a temperature of 330 K. Drying has been effected in a vacuum drier at a temperature of 330 K. The foil 14 $\mu$m thick of green colour and specific conductivity of $2 \times 10^{-2} \Omega^{-1}$ cm$^{-1}$ at the room temperature has been obtained.

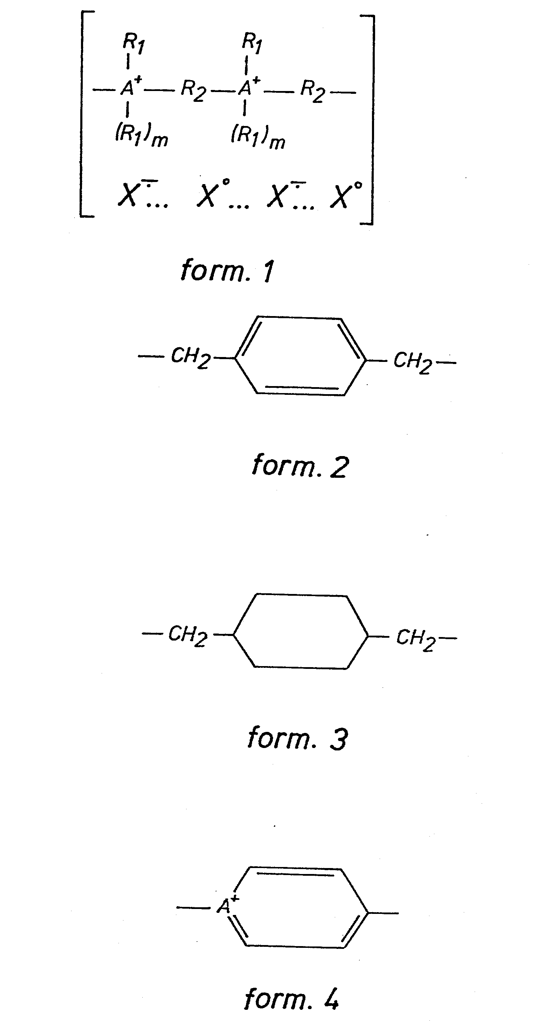

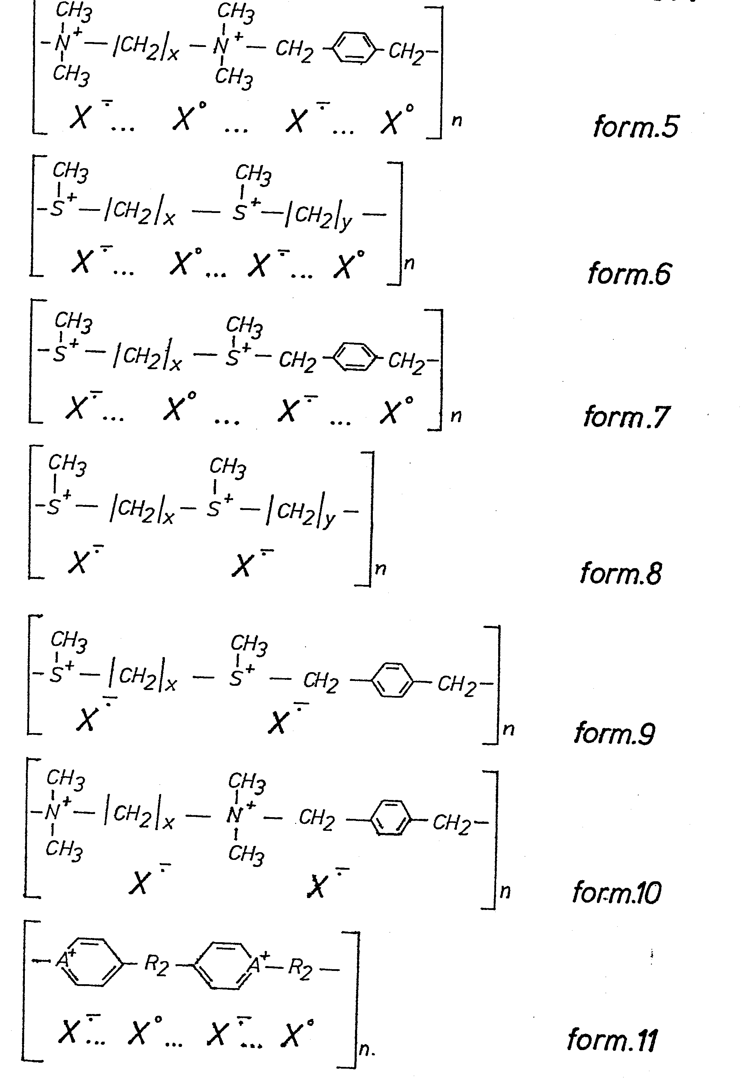

## Claims

1. A method of manufacturing high-molecular electrically conducting material by means of doping the dissolved polymer with the admixtures of organic matter and spreading the solution onto a base, characterized in that said method comprises adding to the dissolved polymer 0.1 - 5% / by weight in relation to polymer/ of the admixture of high-molecular compound containing iterative monomeric units of general formula 1, where $R_1$ denotes the methyl group, $R_2$ denotes independently the group of formula 2, the group of formula 3 or the group of formula $/-CH_2-/_x$, where x denotes the number 3-10, A denotes independently the atom of sulphur, nitrogen, phosphorus or arsenic, m being 0 if A denotes the sulphur atom or m being 1 if A denotes the atom of nitrogen, phosphorus or arsenic, or the substituent A is a heteroatom in the aromatic ring of formula 4; the substituent $R_2$ denotes then independently the group of formula $/-CH_2-/_x$, where x is as above, the group of formula $-CH = CH-$ or $-CH_2-CH_2$, $x^-$ denotes the anion-radical 7, 7, 8, 8 - -tetracyanoquinodimethane and $x^o$ denotes the neutral molecule 7, 7, 8, 8 - tetracyanoquinodimethane, the molar ratio $[x^o]/[x^-]$ having the value given by the inequality $0 < [x^o]/[x^-] \leqslant 1$.

2. A method of manufacturing high-molecular electrically conducting material by means of doping the dissolved polymer with the admixtures of organic matter and spreading the solution onto a base, characterized in that said method comprises adding to the dissolved polymer 0.1 - 5% /by weight in relation to polymer/ of the admixture of high-molecular compound containing iterative monomeric units of general formula 1, where $R_1$ denotes the methyl group, $R_2$ denotes independently the group of formula 2, the group of formula 3 or the group of formula $/-CH_2/_x$, where x denotes the number 3 - 10, A denotes independently the atom of sulphur, nitrogen, phosphorus or arsenic, m being 0 if A denotes the sulphur atom or m being 1 if A denotes the atom of nitrogen, phosphorus or arsenic, or the substituent A is a heteroatom in the aromatic ring of formula 4; the substituent $R_2$ denotes then independently the group of for-mula $/-CH_2-/_x$, where x is as above, the group of formula $-CH = CH-$ or $-CH_2-CH_2-$, $x^-$ denotes the anion-radical 7, 7, 8, 8,- tetracyanoquinodimethane, the molar ratio $[x]/[x^-]$ being equal to 0 and adding 0.1 -3% /by weight in relation to polymer/ of tetracyanoquinodimethane.

2. A method of manufacturing high-molecular electrically conducting material by means of doping the dissolved polymer with the admixtures of organic matter and spreading the solution onto a base, characterized in that said method comprises adding to the dissolved polymer 0.1 - 5% /by weight in relation to polymer/ of the admixture of high-

-molecular compound containing iterative monomeric units of general formula 1, where $R_1$ denotes the methyl group, $R_2$ denotes independently the group of formula 2, the group of formula 3 or the group of formula $/-CH_2-/_x$, where x denotes the number 3 - 10, A denotes independently the atom of sulphur, nitrogen, phosphorus or arsenic, m being 0 if A denotes the sulphur atom or m being 1 if A denotes the atom of nitrogen, phosphorus or arsenic, or the substituent A is a heteroatom in the aromatic ring of formula 4; the substituent $R_2$ denotes then independently the group of formula $/-CH_2-/_x$, where x is as above, the group of formula $-CH = CH-$ or $-CH_2-CH_2-$, $x^-$ denotes anion-radical from the group of acceptors capable of forming high-conductivity complexes with charge transfer, comprising the derivatives of tetracyanoquinodimethane such as dibromotetracyanoquinodimethane, tetrafluorotetracyanoquinodimethane and dichlorotetracyanoquinodimethane, tetracyanonaphthaloquinodimethane, o-chloranil, p-benzoquinone and $x^o$ denotes neutral molecule from the group of acceptors capable of forming high-conductivity complexes with charge transfer, comprising the derivatives of tetracyanoquinodimethane such as dibromotetracyanoquinodimethane, tetrafluorotetracyanoquinodimethane and dichlorotetracyanoquinodimethane, tetracyanonaphthaloquinodimethane, o-chloranil, p-benzoquinone; the molar ratio $[x^o]/[x^-]$ having the value given by the in-

equality $0 < [x^0]/[x^-] \leqslant 1$.

4. A method of manufacturing high-molecular electrically conducting material by means of doping the dissolved polymer with the admixtures of organic matter and spreading the solution onto a base, characterized in that said method comprises adding to the dissolved polymer 0.1 - 5% /by weight in relation to polymer/ of the admixture of high-molecular compound containing iterative monomeric units of general formula 1, where $R_1$ denotes the methyl group, $R_2$ denotes independently the group of formula 2, the group of formula 3 or the group of formula $/-CH_2-/_x$, where x denotes the number 3 -10, A denotes independently the atom of sulphur, nitrogen, phosphorus or arsenic, m being 0 if A denotes the sulphur atom or m being 1 if A denotes the atom of nitrogen, phosphorus or arsenic, or the substituent A is a heteroatom in the aromatic ring of formula 4; the substituent $R_2$ denotes then independently the group of formula $/-CH_2-/_x$, where x is as above, the group of formula $-CH = CH-$ or $-CH_2-CH_2-$, $x^-$ denotes anion-radical from the group of acceptors capable of forming high-conductivity complexes with charge transfer, comprising the derivatives of tetracyanoquinodimethane such as dibromotetracyanoquinodimethane, tetrafluorotetracyanoquinodimethane and dichlorotetracyanoquinodimethane, tetracyanonaphthaloquinodimethane, o-chloranil, p-benzoquinone; the molar ratio $[x^0]/[x^-]$

being equal to 0 and adding 0.1 - 3% /by weight in relation to polymer/ of neutral molecules from the group of acceptors capable of forming high-conductivity complexes with charge transfer comprising the derivatives of tetracyanoquinodimethane such as dibromotetracyanoquinodimethane, tetrafluorotetracyanoquinodimethane and dichlorotetracyanoquinodimethane, tetracyanonaphthaloquinodimethane, o-chloranil, p-benzoquinone.

$$\left[ \begin{array}{c} \overset{R_1}{\underset{(R_1)_m}{\mid}} \quad \overset{R_1}{\underset{(R_1)_m}{\mid}} \\ -A^+ - R_2 - A^+ - R_2 - \\ \end{array} \right]$$

$$X^{\bar{\phantom{.}}}... \quad X^{\circ}... \quad X^{\bar{\phantom{.}}}... \quad X^{\circ}$$

*form. 1*

$$-CH_2- \bigcirc -CH_2-$$

*form. 2*

$$-CH_2- \bigcirc -CH_2-$$

*form. 3*

$$-\overset{\phantom{+}}{A^+}\bigcirc-$$

*form. 4*

$$\left[ \begin{array}{c} \overset{CH_3}{\underset{CH_3}{-N^+}} - |CH_2|_x - \overset{CH_3}{\underset{CH_3}{N^+}} - CH_2 - \langle C_6H_4 \rangle - CH_2 - \\ X^-... \quad X^\circ ... \quad X^-... \quad X^\circ \end{array} \right]_n$$

form.5

$$\left[ \begin{array}{c} \overset{CH_3}{-S^+} - |CH_2|_x - \overset{CH_3}{S^+} - |CH_2|_y - \\ X^-... \quad X^\circ ... \quad X^-... \quad X^\circ \end{array} \right]_n$$

form.6

$$\left[ \begin{array}{c} \overset{CH_3}{-S^+} - |CH_2|_x - \overset{CH_3}{S^+} - CH_2 - \langle C_6H_4 \rangle - CH_2 - \\ X^-... \quad X^\circ ... \quad X^-... \quad X^\circ \end{array} \right]_n$$

form.7

$$\left[ \begin{array}{c} \overset{CH_3}{-S^+} - |CH_2|_x - \overset{CH_3}{S^+} - |CH_2|_y - \\ X^- \qquad\qquad X^- \end{array} \right]_n$$

form.8

$$\left[ \begin{array}{c} \overset{CH_3}{-S^+} - |CH_2|_x - \overset{CH_3}{S^+} - CH_2 - \langle C_6H_4 \rangle - CH_2 - \\ X^- \qquad\qquad X^- \end{array} \right]_n$$

form.9

$$\left[ \begin{array}{c} \overset{CH_3}{\underset{CH_3}{-N^+}} - |CH_2|_x - \overset{CH_3}{\underset{CH_3}{N^+}} - CH_2 - \langle C_6H_4 \rangle - CH_2 - \\ X^- \qquad\qquad X^- \end{array} \right]_n$$

form.10

$$\left[ \begin{array}{c} - A^+ - \langle C_6H_4 \rangle - R_2 - \langle C_6H_4 \rangle - A^+ - R_2 - \\ X^-... \quad X^\circ ... \quad X^-... \quad X^\circ \end{array} \right]_{n.}$$

form.11